# EUROPÄISCHE PATENTANMELDUNG

(11) **EP 4 775 998 A1**
(43) Veröffentlichungstag der Anmeldung: **15.07.2026**
(21) Anmeldenummer: 26150944.2
(22) Anmeldetag: 09.01.2026
(51) Int. Cl.: G01R 19/165, G01R 31/28, G01R 1/04, E05B 47/00

(54) **PRÜFGERÄT**

(30) Priorität: 10.01.2025 AT 5000325 U
(71) Anmelder: Peneder Bau-Elemente GmbH, 4904 Atzbach (AT)
(72) Erfinder: OLINGER, Dominik, 4623 Gunskirchen (AT); RIEPL, Mario, 4060 Leonding (AT)
(74) Vertreter: SONN Patentanwälte GmbH & Co KG

(57) **Zusammenfassung**

Die Erfindung betrifft ein Prüfgerät (1) zur Überprüfung der Funktion einer an das Prüfgerät (1) anschließbaren Tür- und/oder Torkomponente (12), wobei das Prüfgerät (1) folgendes aufweist:
ein Gehäuse (2);
Anschlusskontakte (9) zur elektrischen Verbindung mit der Tür- und/oder Torkomponente (12); und
eine Energieversorgungseinrichtung (15), welche dazu eingerichtet ist, an zumindest einem der Anschlusskontakte (9) eine Versorgungsspannung (Vs) auszugeben;
wobei das Prüfgerät (1) eine Komponentenansteuerungseinrichtung (19) aufweist, welche dazu eingerichtet ist, eine an einem Komponentenkontakt (22) der anschließbaren Tür- und/oder Torkomponente (12) anliegende Komponentenspannung (Vk) über einen der Anschlusskontakte (9) zu erfassen und auf Basis der erfassten Komponentenspannung (Vk) eine Ansteuerungsspannung (Va), insbesondere einer Spannungshöhe der Ansteuerungsspannung (Va), zu bestimmen, mit der die Tür- und/oder Torkomponente (12) ansteuerbar ist.

Des Weiteren betrifft die Erfindung ein Verfahren zur Überprüfung der Funktion einer Tür- und/oder Torkomponente (12).

## Beschreibung

Die Erfindung betrifft ein Prüfgerät zur Überprüfung der Funktion einer an das Prüfgerät anschließbaren Tür- und/oder Torkomponente, insbesondere eines Türöffners, eines Türschlosses und/oder eines Türkontaktschalters, wobei das Prüfgerät folgendes aufweist:
ein Gehäuse;
Anschlusskontakte zur elektrischen Verbindung mit der Tür- und/oder Torkomponente; und
eine Energieversorgungseinrichtung, welche dazu eingerichtet ist, an zumindest einem der Anschlusskontakte eine Versorgungsspannung auszugeben.

Des Weiteren betrifft die Erfindung ein Verfahren zur Überprüfung der Funktion einer Tür- und/oder Torkomponente.

Elektronisch gesteuerte Türen und Tore in Gebäuden werden nach deren Installation üblicherweise hinsichtlich ihrer korrekten Funktionsweise überprüft. Hierfür sind aus dem Stand der Technik Prüfgeräte bekannt, die mit den eingesetzten Tür- und/oder Torkomponenten verbunden werden können, um diese gezielt anzusteuern. Durch die Ansteuerung kann ein Monteur die Funktionsfähigkeit der verbauten Tür- und/oder Torkomponenten überprüfen und sicherstellen, dass diese korrekt installiert wurden und bestimmungsgemäß funktionieren. Diese Prüfgeräte verfügen in der Regel entweder über eine Anzeige, die den Betriebszustand und die Funktionsfähigkeit der Tür- und/oder Torkomponenten wiedergibt, und/oder sie unterstützen den Monteur dabei, eine Sichtkontrolle durchzuführen, um mechanische Fehlfunktionen auszuschließen. Auch bei einwandfreier elektronischer Verbindung der Komponenten können mechanische Fehlfunktionen auftreten, die sich mit solchen Sichtprüfungen durch den Monteur aufdecken lassen.

Ein wesentlicher Nachteil der bekannten Prüfgeräte aus dem Stand der Technik liegt jedoch in ihrer herstellerspezifischen Ausrichtung. In der Regel sind Prüfgeräte nur mit Tür- und/oder Torkomponenten des jeweiligen Herstellers des Prüfgeräts kompatibel und können daher keine Komponenten anderer Hersteller prüfen. Dies führt dazu, dass in Fällen, in denen ein Gebäude oder ein Tür- oder Torsystem Komponenten unterschiedlicher Hersteller enthält, mehrere Prüfgeräte erforderlich sind, die jeweils nur die spezifischen Komponenten eines Herstellers unterstützen. Der Monteur muss dann vor jeder Überprüfung feststellen, von welchem Hersteller die einzelnen Komponenten stammen, um das entsprechende Prüfgerät auszuwählen - sofern eines vorhanden ist -, was den Prozess kompliziert und zeitaufwändig gestaltet.

Im Lichte dieser Ausführungen ist es Aufgabe der vorliegenden Erfindung, die Nachteile des Standes der Technik zu lindern oder gar gänzlich zu beseitigen. Vorzugsweise ist es Aufgabe der vorliegenden Erfindung, ein Prüfgerät der eingangs erwähnten Art zur Verfügung zu stellen, das mit vielen Tür- und/oder Torkomponenten kompatibel ist. Ganz besonders bevorzugt ist es Aufgabe der vorliegenden Erfindung, ein Prüfgerät der eingangs erwähnten Art zur Verfügung zu stellen, das mit Tür- und/oder Torkomponenten mehrerer Hersteller kompatibel ist.

Gelöst wird diese Aufgabe durch ein Prüfgerät nach Anspruch 1 und durch ein Verfahren zur Überprüfung der Funktion einer Tür- und/oder Torkomponente nach Anspruch 10.

Erfindungsgemäß ist bei einem Prüfgerät der eingangs erwähnten Art vorgesehen, dass das Prüfgerät eine Komponentenansteuerungseinrichtung aufweist, welche dazu eingerichtet ist, eine an einem Komponentenkontakt der anschließbaren Tür- und/oder Torkomponente anliegende Komponentenspannung über einen der Anschlusskontakte zu erfassen und auf Basis der erfassten Komponentenspannung eine Ansteuerungsspannung zu bestimmen, mit der die Tür- und/oder Torkomponente ansteuerbar ist. Durch Erfassen der Komponentenspannung kann die Komponentenansteuerungseinrichtung die bestimmungsgemäße Ansteuerungsspannung eruieren, die erforderlich ist, um eine an das Prüfgerät angeschlossene Tür- und/oder Torkomponente anzusteuern. Der Erfindung liegt die Erkenntnis zugrunde, dass der grundlegende Aufbau vieler Tür- und/oder Torkomponenten herstellerübergreifend im Wesentlichen gleich oder ähnlich ist, allerdings unterschiedlich hohe Ansteuerungsspannungen erforderlich sind, um die Tür- und/oder Torkomponente anzusteuern. Beispielsweise reagieren bzw. schalten viele Tür- und/oder Torkomponenten beim Anlegen der Versorgungsspannung an einen entsprechenden Komponentenkontakt zum Schalten der Tür- und/oder Torkomponente (High-Level), während andere Tür- und/oder Torkomponenten anderer Hersteller auf das Anlegen von Bezugspotential, beispielsweise 0 V, reagieren bzw. schalten (Low-Level). Dies ist auf die interne Verschaltung der Tür- und/oder Torkomponente zurückzuführen, die von Hersteller zu Hersteller variieren kann. Um die Höhe der Ansteuerungsspannung zu bestimmen, kann zunächst die Tür- und/oder Torkomponente mit dem Prüfgerät verbunden werden, indem die Anschlusskontakte des Prüfgeräts mit den Komponentenkontakten der Tür- und/oder Torkomponente verbunden werden. Die Verbindung zwischen dem Prüfgerät und der Tür- und/oder Torkomponente kann mittels einer oder mehrerer Verbindungsleitungen erfolgen. Die Verbindungsleitungen können zu einem Verbindungskabel zusammengefasst sein. Nach der Verbindung des Prüfgeräts mit der Tür- und/oder Torkomponente kann die Tür- und/oder Torkomponente mit elektrischer Energie durch Anlegen der Versorgungsspannung versorgt werden. Dadurch kann die Tür- und/oder Torkomponente initialisiert werden, falls diese beispielsweise einen Mikrocontroller mit einem Steuerungsprogramm besitzt. An zumindest einem Komponentenkontakt kann in weiterer Folge eine Komponentenspannung, beispielsweise eine Komponentenversorgungsspannung, die eine Türkomponente mit Energie versorgt, oder ein Bezugspotential, mit dem Prüfgerät erfasst werden. Bei dem Komponentenkontakt kann es sich beispielsweise um einen Eingangskontakt einer Komponentensteuerung der Tür- und/oder Torkomponente handeln, der auf Schaltflanken oder Spannungsimpulse reagiert. Ein solcher Eingangskontakt kann mit einem elektrischen Widerstand auf ein definiertes Spannungsniveau gebracht sein, beispielsweise auf das Bezugspotential (Pull-Down-Widerstand) oder auf die Versorgungsspannung (Pull-Up-Widerstand). Der Eingangskontakt kann dazu eingerichtet sein die Tür- und/oder Torkomponente zu schalten, wenn das definierte Spannungsniveau geändert wird, was beispielsweise durch Anlegen einer Ansteuerungsspannung erfolgen kann. Wenn die erfasste Komponentenspannung hoch ist, beispielsweise im Wesentlichen der Versorgungsspannung entspricht, kann zum Beispiel davon ausgegangen werden, dass die Tür- und/oder Torkomponente durch Anlegen einer im Vergleich zur erfassten Komponentenspannung niedrigeren Ansteuerungsspannung, beispielsweise des Bezugspotentials, angesteuert werden kann. Wenn die erfasste Komponentenspannung niedrig ist, beispielsweise im Wesentlichen dem Bezugspotential entspricht, kann zum Beispiel davon ausgegangen werden, dass die Tür- und/oder Torkomponente durch Anlegen einer im Vergleich zur erfassten Komponentenspannung höheren Ansteuerungsspannung, beispielsweise der Versorgungsspannung, angesteuert werden kann. Nach Bestimmen der Ansteuerungsspannung, insbesondere deren Spannungshöhe, kann diese von dem Prüfgerät ausgegeben werden, um die Tür- und/oder Torkomponente anzusteuern. Ein das Prüfgerät bedienender Monteur kann bei der Ansteuerung der Tür- und/oder Torkomponente beispielsweise durch Sichtkontrolle erkennen, ob Tür- und/oder Torkomponente korrekt funktioniert. Bei einer Ausführungsform kann das Prüfgerät eine Kontrollanzeige aufweisen, die anzeigt, dass die Ansteuerungsspannung ausgegeben wird. Dadurch wird vermieden, dass der Monteur davon ausgeht, dass die Ansteuerungsspannung ausgegeben wird, obwohl dies nicht der Fall ist, und das Nichtreagieren der Tür- und/oder Torkomponente als Fehlfunktion deutet. Das Gehäuse des Prüfgeräts kann beispielsweise aus Kunststoff bestehen. Die Anschlusskontakte können in oder an dem Gehäuse angeordnet sein. Das Gehäuse kann vorzugsweise mit einer Hand gegriffen und getragen werden. Die Energieversorgungseinrichtung und die Komponentenansteuerungseinrichtung können in das Gehäuse integriert sein. Die Versorgungsspannung kann beispielsweise mindestens 10 V, vorzugsweise 12 V oder 24 V, betragen. Die Energieversorgungseinrichtung kann dazu ausgebildet sein, das gesamte Prüfgerät und auch die Tür- und/oder Torkomponente mit elektrischer Energie zu versorgen. Insbesondere kann die Energieversorgungseinrichtung die Komponentenansteuerungseinrichtung mit elektrischer Energie versorgen. Bevorzugt ist, wenn zumindest drei Anschlusskontakte vorgesehen sind. Die Tür- und/oder Torkomponente kann beispielsweise als Tür- und/oder Toröffner, als Tür- und/oder Torschloss oder als Tür- und/oder Torkontaktschalter ausgebildet sein. Ein solcher Tür- und/oder Toröffner kann beispielsweise einen Motor oder eine elektrische Spule aufweisen, mit denen ein Schließelement zwischen einer Offen- und einer Schließstellung verschoben werden kann, sodass eine Türe oder ein Tor von einer Person geöffnet werden kann. Ein Tür- und/oder Torschloss kann ebenfalls einen Motor oder eine Spule aufweisen, mit denen ein Schließelement zwischen einer Offen- und einer Schließstellung verschoben werden kann, sodass eine Türe oder ein Tor verschlossen werden kann. Mit einem Tür- und/oder Torkontaktschalter kann eine Position, insbesondere eine Schließposition, eines Türblattes oder eines Tores festbestellt werden. Die Tür- und/oder Torkomponente kann bei einer Ausführungsform der Erfindung auch als Riegelschaltkontakt zur Überwachung eines Türriegels ausgebildet sein. Die Tür- und/oder Torkomponente kann bei einer Ausführungsform der Erfindung auch als Tür- und/oder Torantrieb ausgebildet sein. Ein Tür- und/oder Torantrieb kann eine Tür bzw. ein Tor aktuieren. Die Tür- und/oder Torkomponente kann in einem in eine Tür oder in ein Tor eingebauten Zustand vorliegen. Alternativ kann die Tür- und/oder Torkomponente auch ausgebaut sein, also nicht in eine Tür oder in ein Tor integriert sein. Die Komponentenansteuerungseinrichtung kann einen Mikroprozessor oder einen Mikrocontroller aufweisen und bei einer Ausführungsform der Erfindung die Steuerung des gesamten Prüfgeräts durchführen. Mit anderen Worten kann die Komponentenansteuerungseinrichtung auch die zentrale Steuerung des Prüfgeräts bilden. Allfällige Schalter und Knöpfe an dem Prüfgerät können mit der zentralen Steuerung verbunden sein.

Bevorzugt ist, wenn die Komponentenansteuerungseinrichtung dazu eingerichtet ist, die Komponentenspannung mittels einer Messeinheit zu erfassen und die Ansteuerungsspannung an einem der Anschlusskontakte, insbesondere an jenem Anschlusskontakt, über den die Komponentenspannung gemessen wird, auszugeben, wobei die Ansteuerungsspannung eine erste Spannungshöhe aufweist, wenn die gemessene Komponentenspannung unterhalb einer Spannungsschwelle liegt, und die Ansteuerungsspannung eine zweite Spannungshöhe aufweist, wenn die gemessene Komponentenspannung oberhalb der Spannungsschwelle liegt. Durch den Vergleich der erfassten Komponentenspannung mit der Spannungsschwelle kann entschieden werden, ob eine Ansteuerungsspannung mit einer ersten Spannungshöhe oder mit einer zweiten Spannungshöhe ausgegeben wird. Wenn die Komponentenspannung der Spannungsschwelle entspricht, kann beispielsweise die erste oder die zweite Spannungshöhe ausgegeben werden. Die erste Spannungshöhe unterscheidet sich von der zweiten Spannungshöhe. Bevorzugt ist die erste Spannungshöhe größer als die zweite Spannungshöhe. Insbesondere ist die zweite Spannungshöhe geringer als die Versorgungsspannung. Die Spannungsschwelle liegt vorzugsweise bei im Wesentlichen 1500 mV (Millivolt), kann aber auch beispielsweise bei 1000 mV oder 2000 mV liegen. Die Messeinheit kann zum Erfassen der Komponentenspannung beispielsweise einen Messwiderstand aufweisen. Mittels eines Analog-Digital-Wandlers kann die an dem Messwiderstand abfallende Spannung gemessen werden und von einem Mikrocontroller oder Mikroprozessor verarbeitet werden, insbesondere mit der Spannungsschwelle verglichen werden. Möglich ist aber zum Beispiel auch, dass die Komponentenansteuerungseinrichtung einen Komparator aufweist, dessen Schaltschwelle der Spannungsschwelle entspricht. Ein Ausgang des Komparators oder der Mikrocontroller bzw. der Mikroprozessor kann mit zumindest einem Schalter, beispielsweise einem Transistor, verbunden sein, welcher dazu eingerichtet ist, in Abhängigkeit der Höhe der Komponentenspannung die Ansteuerungsspannung gemäß der ersten Spannungshöhe oder gemäß der zweiten Spannungshöhe an einem der Anschlusskontakte auszugeben. Alternativ können zwei Schalter vorgesehen und mit einem Anschlusskontakt verbunden sein, wobei ein erster Schalter dazu eingerichtet ist, eine Ansteuerungsspannung gemäß der ersten Spannungshöhe an dem Anschlusskontakt auszugeben, und ein zweiter Schalter dazu eingerichtet ist, eine Ansteuerungsspannung gemäß der zweiten Spannungshöhe an dem Anschlusskontakt auszugeben. Möglich ist auch, eine steuerbare Spannungsquelle einzusetzen, welche mit dem Mikrocontroller bzw. Mikroprozessor oder dem Komparator verbunden sein kann. Bei einer bevorzugten Ausführungsform der Erfindung wird die Ansteuerungsspannung gemäß der ersten oder der zweiten Spannungshöhe an jenem Anschlusskontakt ausgegeben, an dem zuvor die Komponentenspannung erfasst wurde. Ein solcher Anschlusskontakt kann als Ansteuerungsanschlusskontakt bezeichnet werden.

Bei einer Ausführungsform ist vorgesehen, dass zumindest drei Anschlusskontakte an dem Gehäuse vorgesehen sind, wobei ein Bezugspotentialanschlusskontakt dazu eingerichtet ist, ein Bezugspotential auszugeben, ein Energieversorgungsanschluss - kontakt dazu eingerichtet ist, die Versorgungsspannung auszugeben, und ein Ansteuerungsanschlusskontakt dazu eingerichtet ist, die Ansteuerungsspannung, insbesondere einen Ansteuerungsspannungssprung oder -impuls, auszugeben. Das Bezugspotential liegt vorzugsweise bei 0 V. Die Versorgungsspannung ist höher als das Bezugspotential und liegt vorzugsweise bei zumindest 10 V. Bei einer Ausführungsform der Erfindung ist die Versorgungsspannung in Stufen oder stufenlos einstellbar. An dem Ansteuerungsanschlusskontakt kann die Ansteuerungsspannung ausgegeben werden. Die Ansteuerungsspannung kann eine Spannungshöhe aufweisen, die dem Bezugspotential oder der Versorgungsspannung entspricht. Die Ansteuerungsspannung kann aber auch eine Spannungshöhe aufweisen, die zwischen dem Bezugspotential und der Versorgungsspannung liegt. Die Form der Ansteuerungsspannung kann die Form eines Spannungssprunges oder eines Spannungsimpulses aufweisen. Ein Spannungssprung weist eine Spannungsflanke auf. Die Spannungshöhe bezieht sich auf die elektrische Spannung des Spannungsimpulses oder nach dem Spannungssprung.

Eine vorteilhafte Ausgestaltung der Erfindung ergibt sich, wenn die erste Spannungshöhe im Wesentlichen der Versorgungsspannung und die zweite Spannungshöhe im Wesentlichen dem Bezugspotential entspricht.

Um ungewollte Ansteuerungen der Tür- und/oder Torkomponente zu verhindern, kann an dem Gehäuse ein Betätigungsschalter vorgesehen sein, welcher dazu eingerichtet ist, die Komponentenansteuerungseinrichtung zu veranlassen, die Versorgungsspannung an dem Energieversorgungsanschlusskontakt auszugeben und/oder die Ansteuerungsspannung an dem Ansteuerungsanschlusskontakt auszugeben, vorzugsweise wenn die Ansteuerungsspannung zeitlich versetzt zur Versorgungsspannung ausgegeben wird. Bei einer vorteilhaften Ausgestaltung der Erfindung ist vorgesehen, dass der Betätigungsschalter zunächst die Komponentenansteuerungseinrichtung ansteuert, die Versorgungsspannung auszugeben. In weiterer Folge bestimmt die Komponentenansteuerungseinrichtung, vorzugsweise nach einer Wartezeit von zumindest 5 oder von zumindest 7 Sekunden, die Ansteuerungsspannung. Die Wartezeit ermöglicht, dass die an das Prüfgerät angeschlossene Tür- und/oder Torkomponente initialisiert wird. Nach Bestimmung der Ansteuerungsspannung, insbesondere der Spannungshöhe der Ansteuerungsspannung, wird diese an dem Anschlusskontakt ausgegeben, vorzugsweise an demselben, an dem die Ansteuerungsspannung bestimmt wurde. Die Ansteuerungsspannung kann für eine vorgegebene Zeitdauer ausgegeben werden.

Günstig ist, wenn die Komponentenansteuerungseinrichtung dazu eingerichtet ist, nach Ausgabe der Versorgungsspannung eine Wartezeit von zumindest drei Sekunden, zumindest fünf Sekunden oder zumindest sieben Sekunden einzuhalten, bevor die Ansteuerungsspannung bestimmt wird. Durch Tests hat sich herausgestellt, dass viele Tür- und/oder Torkomponenten nach einer Wartezeit von zumindest sieben Sekunden initialisiert sind, d.h. allfällige Steuerprogramme in Mikroprozessoren bzw. Mikrocontroller geladen und gegebenenfalls Energiespeicher geladen sind.

Um auch Tür- und/oder Torkomponente an Orten überprüfen zu können, an denen keine Energieversorgung, beispielsweise durch ein Energieversorgungsnetz, zur Verfügung steht, ist es günstig, wenn die Energieversorgungseinrichtung eine Batterie oder einen Akkumulator aufweist. Die Batterie kann auswechselbar ausgestaltet sein. Der Akkumulator kann wiederaufladbar sein.

Eine vorteilhafte Ausgestaltung der Erfindung ergibt sich, wenn zumindest ein Anschlusskontakt für einen Tür- und/oder Torkontaktschalter vorgesehen ist und eine Anzeigeeinrichtung mit dem Anschlusskontakt für den Tür- und/oder Torkontaktschalter verbunden ist, wobei die Anzeigeeinrichtung dazu eingerichtet ist, eine an dem Anschlusskontakt für den Tür- und/oder Torkontaktschalter anliegende Kontaktspannung zu signalisieren. Die Signalisierung der Anzeigeeinrichtung erfolgt beispielsweise durch Leuchten einer LED, wenn die Kontaktspannung höher ist, als ein vorgegebener Wert, und beispielsweise im Wesentlichen der Versorgungsspannung entspricht. Tür- und/oder Torkontaktschalter sind dazu eingerichtet, Endlagen, vorzugsweise einen geschlossenen bzw. offenen Zustand der Tür oder des Tores, zu signalisieren. An den Anschlusskontakt für einen Tür- und/oder Torkontaktschalter kann auch ein Riegelschaltkontakt angeschlossen und überprüft werden. Ein solcher Riegelschaltkontakt dient zur Überwachung, ob ein Türriegel aus- oder eingefahren ist. Der Tür- und/oder Torkontaktschalter, insbesondere ein Schalterelement des Tür- und/oder Torkontaktschalter, kann beispielsweise eine Stromschleife schließen oder öffnen, wenn ein Tor oder eine Tür geöffnet wird. Zu diesem Zweck kann der Tür- und/oder Torkontaktschalter in einen Türrahmen oder einen Türflügel integriert sein. Der Tür- und/oder Torkontaktschalter kann aber auch, abhängig von der Position des Türblattes oder des Tores, unterschiedliche Kontaktschalterspannungen ausgeben. Der Tür- und/oder Torkontaktschalter kann beispielsweise das Bezugspotential ausgeben, wenn die Tür oder das Tor geöffnet ist, und die Versorgungsspannung ausgeben, wenn die Tür oder das Tor geschlossen ist. Die Ausgabe der Spannungen kann auch umgekehrt sein. Der Kontaktschalter kann mit einem eigens dazu vorgesehenen Anschlusskontakt des Prüfgeräts verbunden werden, welcher mit einer Anzeigeeinrichtung, beispielsweise einer LED, direkt oder indirekt verbunden sein kann. Wenn der Kontaktschalter durch Öffnen oder Schließen der Tür bzw. des Tores betätigt wird, wird auch die Kontaktschalterspannung verändert, was durch das Prüfgerät erfasst und mit der Anzeigevorrichtung angezeigt werden kann. Ein Monteur kann somit durch Öffnen oder Schließen des Tores bzw. der Tür mit Blick auf die Anzeigevorrichtung erkennen, ob ein Kontaktschalter korrekt installiert ist.

Da Tür- und/oder Torkomponenten unterschiedlicher Hersteller oftmals mit unterschiedlichen Spannungen betrieben werden, ist es günstig, wenn die Energieversorgungseinrichtung dazu eingerichtet ist, die Versorgungsspannung gemäß zumindest zwei unterschiedlicher Versorgungsspannungslevel auszugeben. Bei einer Ausführungsform kann vorgesehen sein, dass sich zwei unterschiedliche Anschlusskontakte an dem Gehäuse befinden, von denen der eine die Versorgungsspannung gemäß einem ersten Versorgungsspannungslevel und der andere die Versorgungsspannung gemäß einem zweiten Versorgungsspannungslevel ausgibt.

Bevorzugt ist aber, wenn eine Auswahlvorrichtung, insbesondere zumindest ein Schalter, vorgesehen ist, sodass ein erster Versorgungsspannungslevel, insbesondere im Wesentlichen 12 Volt, oder ein zweiter Versorgungsspannungslevel, insbesondere im Wesentlichen 24 V, auswählbar ist. Dadurch Betätigen der Auswahlvorrichtung kann der Versorgungsspannungslevel der Versorgungsspannung umgestellt werden. Beispielsweise kann an dem Energieversorgungsanschlusskontakt in einer ersten Stellung der Auswahlvorrichtung die Versorgungsspannung gemäß dem ersten Versorgungsspannungslevel und in einer zweiten Stellung der Auswahlvorrichtung die Versorgungsspannung gemäß dem zweiten Versorgungsspannungslevel ausgegeben werden. Die Versorgungsspannungslevel von 12 V und 24 V haben sich als vorteilhaft erwiesen, weil viele auf dem Markt erhältliche Tür- und/oder Torkomponenten mit einer Versorgungsspannung in einer solchen Höhe betrieben werden. Zum anderen werden durch die genannten Spannungshöhen Schäden an Tür- und/oder Torkomponenten vermieden. Die Auswahlvorrichtung kann beispielsweise zwei Tasten oder Druckknöpfe aufweisen. Alternativ kann beispielsweise auch ein Umschaltknopf oder Umschalter vorgesehen sein.

Eine besonders vorteilhafte Ausgestaltung der Erfindung ergibt sich, wenn das Prüfgerät als Handgerät ausgebildet ist. Ein solches Handgerät kann mit einer Hand getragen bzw. in einer Hand gehalten werden. Bevorzugt weist das Prüfgerät eine Länge zwischen 80 mm und 250 mm, eine Breite zwischen 50 mm und 140 mm sowie eine Höhe zwischen 20 mm und 60 mm auf. Bevorzugt weist das Prüfgerät ein Gewicht unter 1 kg, vorzugsweise unter 0,5 kg auf.

Die Erfindung betrifft auch ein Verfahren zur Überprüfung der Funktion einer Tür- und/oder Torkomponente, wobei ein Prüfgerät der oben beschriebenen Art mit den Anschlusskontakten mittels zumindest einer Verbindungsleitung direkt oder indirekt an eine Tür- und/oder Torkomponente, insbesondere an einen Türöffner, ein Türschloss oder einen Türkontaktschalter, angeschlossen wird, wobei das Verfahren die folgenden Schritte aufweist:
Erfassen einer an einem Komponentenkontakt der Tür- und/oder Torkomponente anliegenden Komponentenspannung über einen der Anschlusskontakte, insbesondere über einen Ansteuerungsanschlusskontakt;
Bestimmen einer Ansteuerungsspannung, insbesondere einer Spannungshöhe der Ansteuerungsspannung, mit der die Tür- und/oder Torkomponente ansteuerbar ist, auf Basis der erfassten Komponentenspannung;
Ansteuern der Tür- und/oder Torkomponente durch Ausgeben der Ansteuerungsspannung an einem der Anschlusskontakte, vorzugsweise in Form eines Ansteuerungsspannungssprungs oder -impuls.

Die oben in Zusammenhang mit dem Prüfgerät beschriebenen Merkmale, Effekte und Vorteile sind auf das Verfahren zur Überprüfung der Funktion einer Tür- und/oder Torkomponente übertragbar. Bei dem erfindungsgemäßen Verfahren wird ein Prüfgerät mit einer Tür- und/oder Torkomponente über zumindest eine Verbindungsleitung verbunden. Die Verbindung kann dabei direkt zwischen dem Prüfgerät und der Tür- und/oder Torkomponente vorliegen. Alternativ ist auch möglich, die Tür- und/oder Torkomponente indirekt, beispielsweise über ein dazwischengeschaltetes Verbindungsmodul, einen Verteilerkasten oder einen Anschlusskasten, mit dem Prüfgerät zu verbinden. Nach dem Verbinden des Prüfgeräts wird die Ansteuerungsspannung, insbesondere deren Spannungshöhe, bestimmt. Nach der Bestimmung der Ansteuerungsspannung wird diese an einem der Anschlusskontakte ausgegeben, um die Tür- und/oder Torkomponente anzusteuern. Durch die Ausgabe der Ansteuerungsspannung kann die Tür- und/oder Torkomponente aktuiert werden. Ein Monteur kann eine Sicht- und/oder Hörprüfung durchführen, ob nach Ausgabe der Ansteuerungsspannung eine mechanische Bewegung an der Tür- und/oder Torkomponente stattfindet. Beispielsweise kann an einer Tür mit einem Türöffner oder einem Türschloss bei Ausgabe der Ansteuerungsspannung der Monteur hören, ob der Türöffner bzw. das Türschloss aktuiert wird und testen, ob sich die Tür auch öffnen lässt.

Vorteilhaft ist, wenn die Komponentenspannung erfasst wird und an einem der Anschlusskontakte, insbesondere an jenem Anschlusskontakt, über den die Komponentenspannung erfasst wird, die Ansteuerungsspannung ausgegeben wird, wobei die Ansteuerungsspannung eine erste Spannungshöhe aufweist, wenn die gemessene Komponentenspannung unterhalb einer Spannungsschwelle liegt, und die Ansteuerungsspannung eine zweite Spannungshöhe aufweist, wenn die gemessene Komponentenspannung oberhalb der Spannungsschwelle liegt.

Günstig ist, wenn an einem als Ansteuerungsanschlusskontakt ausgebildeten Anschlusskontakt die Komponentenspannung gemessen wird und die Ansteuerungsspannung an dem Ansteuerungsanschlusskontakt ausgegeben wird, vorzugsweise als Ansteuerungsspannungssprung oder -impuls.

Um unbeabsichtigte Ansteuerungen der Tür- und/oder Torkomponente zu vermeiden, kann vorgesehen sein, dass die Versorgungsspannung an einem Energieversorgungsanschlusskontakt und/oder die Ansteuerungsspannung an einem Ansteuerungsanschlusskontakt ausgegeben wird, wenn ein Benutzer einen Betätigungsschalter drückt, vorzugsweise wobei die Ansteuerungsspannung zeitversetzt zur Versorgungsspannung ausgegeben wird. Bevorzugt ist, wenn zunächst die Versorgungsspannung ausgegeben wird und erst danach die Ansteuerungsspannung. Dadurch kann die Tür- und/oder Torkomponente initialisiert werden, bevor sie angesteuert wird.

Vorteilhaft ist, wenn nach Betätigung des Betätigungsschalters die Versorgungsspannung ausgegeben wird, anschließend die Ansteuerungsspannung bestimmt wird und dann die Ansteuerungsspannung ausgegeben wird.

Aus Tests hat sich ergeben, dass es hinsichtlich der Initialisierung der Initialisierung der Tür- und/oder Torkomponente vorteilhaft ist, wenn zwischen der Ausgabe der Versorgungsspannung und der Bestimmung der Ansteuerungsspannung eine Wartezeit von zumindest drei Sekunden, von zumindest 5 Sekunden, von zumindest 6 Sekunden oder von zumindest 7 Sekunden eingehalten wird.

Bei einer Ausführungsform kann ein Benutzer einen von mehreren Versorgungsspannungslevel mittels einer Auswahlvorrichtung auswählen. Beispielsweise können 12 V und 24 V als Versorgungsspannungslevel vorgesehen sein. Die Auswahlvorrichtung kann einen oder mehrere Schalter aufweisen, mit denen der Versorgungsspannungslevel einstellbar ist.

Nachfolgend wird die Erfindung anhand von Figuren näher erläutert, auf die sie allerdings nicht beschränkt sein soll. Es zeigen:
Fig. 1 ein Prüfgerät in einer Ansicht von oben;
Fig. 2 ein schematisches Blockschaltbild eines Prüfgeräts in einem mit einer Türkomponente verbundenen Zustand, wobei die Türkomponente ein Türschloss ist;
Fig. 3 ein schematisches Blockschaltbild eines Prüfgeräts in einem mit einer Türkomponente verbundenen Zustand, wobei die Türkomponente ein Türkontaktschalter ist; und
Fig. 4 einen Prüfungsablauf.

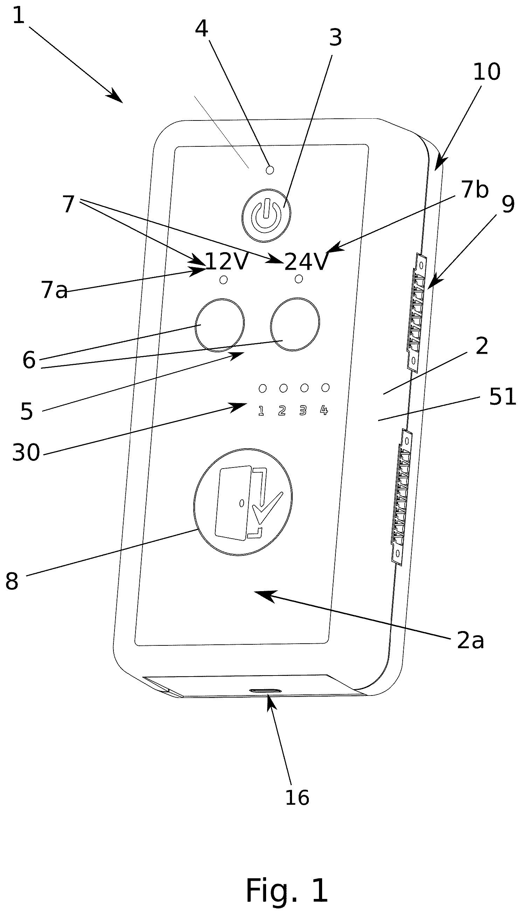

Fig. 1 zeigt ein als Handgerät 51 ausgebildetes Prüfgerät 1 mit einem Gehäuse 2. Das Gehäuse 2 kann beispielsweise aus einem Kunststoff bestehen. An einer Oberseite 2a des Gehäuses 2 befindet sich ein Einschaltknopf 3, mit dem das Prüfgerät 1 eingeschaltet werden kann, sodass dieses betriebsbereit ist. Falls das Prüfgerät 1 für eine bestimmte Zeitdauer nicht verwendet wird, kann dieses automatisch wieder deaktiviert werden. Eine Anzeigeleuchte 4 zeigt an, ob das Prüfgerät 1 eingeschaltet ist. Des Weiteren weist das Prüfgerät 1 eine Auswahlvorrichtung 5 in Form zweier Druckknöpfe 6 auf, mit dem zwischen zwei Versorgungsspannungslevel 7, im gezeigten Ausführungsbeispiel einem ersten Versorgungsspannungslevel 7a von 12 V und einem zweiten Versorgungsspannungslevel 7b von 24 V, umgeschaltet werden kann. An der Oberseite 2a des Gehäuses 2 befindet sich zudem ein Betätigungsschalter 8, mit dem eine unten noch näher beschriebene Ansteuerungsspannung Va an einem der Anschlusskontakte 9 ausgegeben werden kann, die sich an dem Gehäuse 2 befinden. Die Anschlusskontakte 9 können beispielsweise an einer Seitenfläche 10 des Gehäuses 2 angeordnet sein. Bei einer Ausführungsform können manche oder alle Anschlusskontakte 9 in ein Anschlusselement, beispielsweise einen Stecker (nicht gezeigt) oder eine Steckerkupplung, integriert sein.

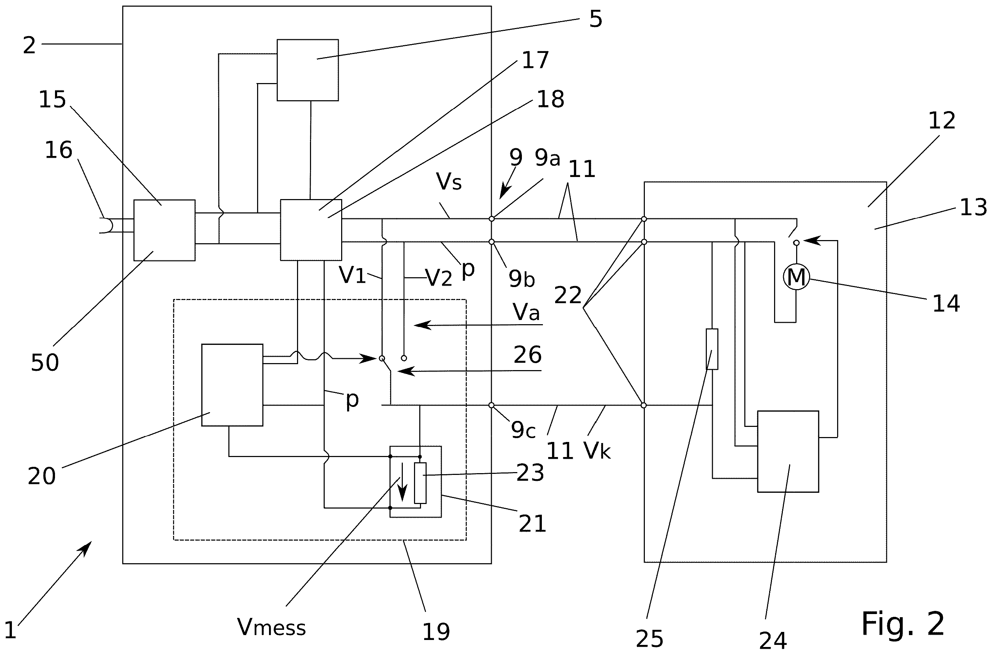

Fig. 2 zeigt ein schematisches und vereinfachtes Blockschaltbild des Prüfgeräts 1, mit dessen Anschlusskontakte 9 mit Verbindungsleitungen 11 verbunden sind. Über die Verbindungsleitungen 11 ist eine Tür- und/oder Torkomponente 12 an das Prüfgerät 1 angeschlossen. Die Verbindungsleitungen 11 sind hierzu mit den Komponentenkontakten 22 der Tür- und/oder Torkomponente 12 verbunden. In der gezeigten Darstellung ist die Tür- und/oder Torkomponente 12 als Türschloss 13 mit einem elektrischen Motor 14 ausgebildet. In Fig. 2 ist das Prüfgerät 1 direkt mit der Tür- und/oder Torkomponente 12 verbunden. Möglich ist aber auch, dass die Verbindung indirekt über ein Verbindungsmodul oder einen Anschlusskasten (nicht gezeigt) erfolgt. Die Tür- und/oder Torkomponente 12 kann freigelegt sein oder sich in einem in einer Tür oder einem Tor eingebauten Zustand befinden.

Das Prüfgerät 1 weist eine Energieversorgungseinrichtung 15 auf, die einen über eine Anschlussbuchse 16 wiederaufladbaren Akkumulator 50 aufweist. Die Energieversorgungseinrichtung 15 kann das gesamte Prüfgerät 1 und die Tür- und/oder Torkomponente 12 mit elektrischer Energie versorgen. Die Energieversorgungseinrichtung 15 ist mit einer Spannungsausgabeeinheit 17 verbunden, welche dazu eingerichtet ist, zumindest zwei unterschiedliche Versorgungsspannungslevel 7 auszugeben, nämlich 12 V und 24 V in dem gezeigten Ausführungsbeispiel. Zu diesem Zweck kann die Spannungsausgabeeinheit 17 zum Beispiel als Gleichspannungswandlereinheit 18, vorzugsweise als Hoch- und/oder Tiefsetzsteller, ausgebildet sein. Möglich ist aber auch, dass die Spannungsausgabeeinheit 17 ein schaltbares Widerstandsnetzwerk aufweist, welches durch Spannungsteiler unterschiedliche Versorgungsspannungslevel 7 ausgeben kann. Die Spannungsausgabeeinheit 17 ist zum Zwecke der Auswahl des Versorgungsspannungslevel 7 mit der Auswahlvorrichtung 5 verbunden. Die Spannungsausgabeeinheit 17 gibt eine Versorgungsspannung Vs gemäß dem gewählten Versorgungsspannungslevel 7 aus, beispielsweise eben 12 V oder 24 V. Die Versorgungsspannung Vs wird der Tür- und/oder Torkomponente 12 an einem Energieversorgungsanschlusskontakt 9a zur Verfügung gestellt. Das Bezugspotential P wird an einem Bezugspotentialanschlusskontakt 9b ausgegeben und ebenfalls der Tür- und/oder Torkomponente 12 zur Verfügung gestellt.

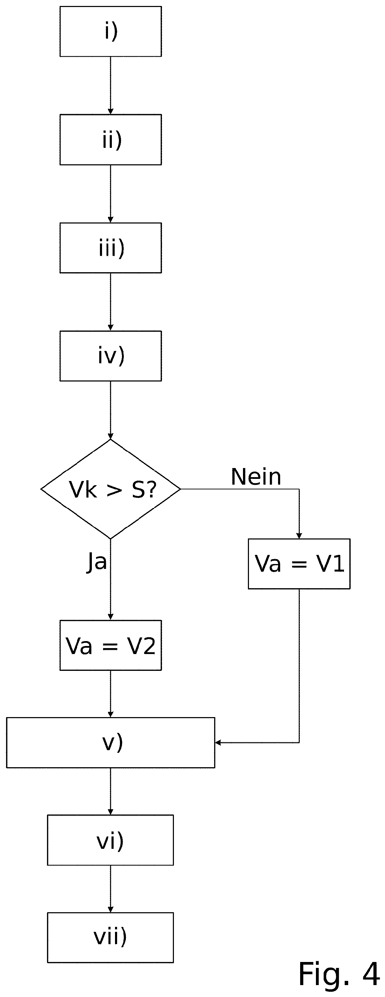

Das Prüfgerät 1 weist eine Komponentenansteuerungseinrichtung 19 auf. Diese umfasst einen Mikrocontroller 20, der bei einer Ausführungsform der Erfindung auch zur Steuerung des gesamten Prüfgeräts 1 ausgebildet sein kann. Die Komponentenansteuerungseinrichtung 19 weist eine Messeinheit 21 auf, welche eine an einem Komponentenkontakt 22 Tür- und/oder Torkomponente 12 ausgegebene Komponentenspannung Vk erfassen kann. In der gezeigten Darstellung ist die Messeinheit 21 hierzu mit einem Ansteuerungsanschlusskontakt 9c des Prüfgeräts 1 verbunden. Die Komponentenansteuerungseinrichtung 19 kann beispielsweise erfassen, ob die Komponentenspannung Vk oberhalb oder unterhalb einer vorgegebenen Spannungsschwelle S liegt (siehe Fig. 4). Die Spannungsschwelle S kann beispielsweise 1,5 V entsprechen. Um zu erfassen, ob die Komponentenspannung Vk oberhalb oder unterhalb einer vorgegebenen Spannungsschwelle S liegt, kann die Messeinheit 21 beispielsweise einen Komparator aufweisen (nicht gezeigt). Möglich ist auch, dass ein Messwiderstand 23 in der Messeinheit 21 vorgesehen ist und die über den Messwiderstand 23 abfallende Spannung Vmess mithilfe eines Analog-Digital-Wandlers gewandelt und in dem Mikrocontroller 20 verarbeitet wird, insbesondere mit der Spannungsschwelle S verglichen wird. Hierzu kann in dem Mikrocontroller 20 ein entsprechendes Programm hinterlegt sein.

Die als Türschloss 13 ausgebildete Tür- und/oder Torkomponente 12 kann über den Komponentenkontakt 22, der mit dem Ansteuerungsanschlusskontakt 9c verbunden ist, angesteuert werden. Zu diesem Zweck kann ein Spannungswechsel, beispielsweise in Form eines Spannungssprunges oder eines Spannungsimpulses, vorgesehen sein. Eine Komponentensteuerung 24 erkennt diesen Spannungswechsel und aktiviert in weiterer Folge den Motor 14 des Türschlosses 13. Um den Spannungswechsel zu erkennen, ist der Komponentenkontakt 22, der mit dem Ansteuerungsanschlusskontakt 9c verbunden ist, auf ein definiertes Spannungsniveau gelegt. In der gezeigten Darstellung erfolgt dies mit einem Pull-Down-Widerstand 25, der den Komponentenkontakt 22 auf das Niveau des Bezugspotentials P zieht. Um das Türschloss 13 anzusteuern, ist daher eine Ansteuerungsspannung Va erforderlich, die einen Spannungswechsel auf ein höheres Spannungsniveau, beispielsweise auf die Versorgungsspannung Vs, enthält. Wenn anstelle eines Pull-Down-Widerstandes 25 ein Pull-Up-Widerstand (nicht gezeigt) verwendet wird, wird der Komponentenkontakt 22 auf die Versorgungsspannung Vs gezogen, wodurch zum Ansteuern des Türschlosses 13 eine Ansteuerungsspannung Va erforderlich ist, die einen Spannungswechsel auf ein niedrigeres Spannungsniveau, beispielsweise das Bezugspotential P, enthält.

Um jene Ansteuerungsspannung Va zu bestimmen, mit der die Tür- und/oder Torkomponente 12 ansteuerbar ist, wird die erfasste Komponentenspannung Vk mit der Spannungsschwelle S verglichen. Wie bereits erwähnt, kann dieser Vergleich beispielsweise mittels eines Komparators oder in dem Mikrocontroller 20 stattfinden. Wenn die erfasste Komponentenspannung Vk unterhalb der Spannungsschwelle S liegt, wird eine erste Spannungshöhe V1 bestimmt. Wenn die erfasste Komponentenspannung Vk oberhalb der Spannungsschwelle S liegt, wird eine zweite Spannungshöhe V2 bestimmt. Die erste Spannungshöhe V1 ist größer als die zweite Spannungshöhe V2. Bevorzugt entspricht die erste Spannungshöhe V1 der Versorgungsspannung Vs und die zweite Spannungshöhe dem Bezugspotential P. Um die Ansteuerungsspannung Va auszugeben, ist in der gezeigten Ausführungsform ein Schalter 26 vorgesehen, der von der Mikrocontroller 20 angesteuert wird. Der Schalter 26, der bei einer Ausführungsform auch in einer Mittelstellung bzw. Ausstellung, in der weder eine Spannungshöhe V1 noch eine Spannungshöhe V2, vorzugsweise keine Spannung, ausgegeben wird, angeordnet sein kann, ist mit dem Ansteuerungsanschlusskontakt 9c verbunden. Alternativ kann beispielsweise auch ein weiterer Schalter vorgesehen sein, der den Schalter 26 von dem Ansteuerungsanschlusskontakt 9c trennt, sodass keine Spannung V1 oder V2 mit Ansteuerungsanschlusskontakt 9c verbunden und die Messung der Komponentenspannung Vk nicht gestört wird. Bei der erwähnten alternativen Ausführungsform mit dem Komparator kann der Komparator den Schalter 26 ansteuern. Der Schalter 26 kann den Ansteuerungsanschlusskontakt 9c mit der Versorgungsspannung Vs oder dem Bezugspotential P verbinden. Dadurch wird eine Ansteuerungsspannung Va mit einem Spannungssprung an den Komponentenkontakt 22, der mit dem Ansteuerungsanschlusskontakt 9c verbunden ist, geleitet. Die Ansteuerungsspannung Va wird von der Komponentensteuerung 24 erkannt, woraufhin der Motor 14 aktiviert wird. Die Aktivierung des Motors 14 kann von einem Monteur akustisch und/oder optisch erkannt werden. Anstelle des Motors 14 kann die Tür- und/oder Torkomponente 12 beispielsweise auch eine Spule oder ein anderes Element enthalten, welches mittels der Ansteuerungsspannung Va aktivierbar ist.

Durch Betätigen des Schalters 26 kann ein Spannungssprung auf die erste V1 oder zweite Spannungshöhe V2 ausgegeben werden. Die Ansteuerungsspannung Va kann bei einer Ausführungsform nach dem Spannungssprung beispielsweise für 2 s anliegen oder bis der Betätigungsschalter 8 erneut gedrückt wird.

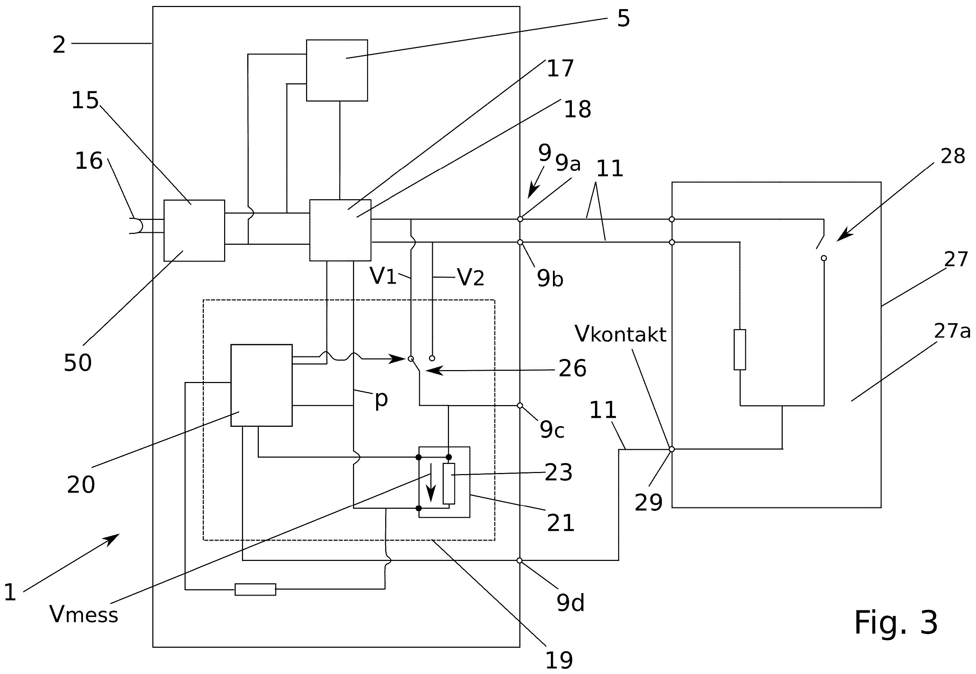

Bei einer Weiterbildung der Erfindung weist das Prüfgerät 1 zumindest ein Anschlusskontakt 9d für einen Tür- und/oder Torkontaktschalter 27 auf. Mit einem Tür- und/oder Torkontaktschalter 27 kann überprüft werden, ob eine Tür bzw. ein Tor geschlossen ist. Ein Schalterelement 28 des Tür- und/oder Torkontaktschalters 27 wird betätigt, wenn sich ein Türblatt oder ein Tor in einer Endlage befindet. Beispielsweise kann das Türblatt einen in eine Zarge eingebauten Türkontaktschalter 27a betätigen, indem das Türblatt auf das Schalterelement 28 drückt und dadurch eine Stromschleife geschlossen wird. Wenn ein Tür- und/oder Torkontaktschalter 27 betätigt wird, gibt dieser aufgrund des geschlossenen oder geöffneten Schalterelements 28 eine Spannung aus. Fig. 3 zeigt einen Türkontaktschalter 27a in einem verbundenen Zustand mit dem Prüfgerät 1. Der Türkontaktschalter 27 ist mit Verbindungsleitungen 11 an das Prüfgerät 1 angeschlossen. Durch die Versorgungsspannung Vs wird der Türkontaktschalter 27a mit elektrischer Energie versorgt. Wenn das Schalterelement geschlossen wird, liegt an einem Ausgang 29 des Türkontaktschalters 27 eine Kontaktspannung Vkontakt an, welche bei geschlossenem Schalterelement 28 im Wesentlichen der Versorgungsspannung Vs entspricht und von dem Mikrocontroller 20 erfasst werden kann. Wenn die Kontaktspannung Vkontakt im Wesentlichen der Versorgungsspannung Vs entspricht, aktiviert der Mikrocontroller 20 in weiterer Folge eine Anzeigeeinrichtung 30, welche beispielsweise eine LED aufweisen kann. Möglich ist auch, dass der Anschlusskontakt direkt mit der Anzeigeeinrichtung 30 verbunden ist und aktiviert wird, sobald Vkontakt im Wesentlichen der Versorgungsspannung Vs entspricht. Durch manuelles Öffnen und Schließen der Tür durch den Monteur kann mit Blick auf die Anzeigeeinrichtung festgestellt werden, ob Tür- und/oder Torkontaktschalter 27 funktioniert. Dies zeigt sich in einer Veränderung der Anzeige der Anzeigeeinrichtung 30. Selbstverständlich können auch mehrere Anschlusskontakte 9d für einen Tür- und/oder Torkontaktschalter 27 vorgesehen sein und die Anzeigeeinrichtung 30 für jeden Anschlusskontakt 9 eine entsprechende Anzeige, insbesondere eine entsprechende LED, aufweisen (siehe Fig. 1).

Der Prüfvorgang der Tür- und/oder Torkomponente 12 kann beispielsweise wie folgt ablaufen (siehe Fig. 4).

In einem ersten Schritt i) verbindet ein Monteur das Prüfgerät 1 mithilfe von Verbindungsleitungen 11 mit der zu überprüfenden Tür- und/oder Torkomponente 12. Die Tür- und/oder Torkomponente 12 kann sich dabei in einem in eine Tür oder in ein Tor eingebauten Zustand befinden. In einem Schritt ii) aktiviert der Monteur das Prüfgerät 1 und wählt einen passenden Versorgungsspannungslevel 7, zum Beispiel 12 V oder 24 V, mithilfe der Auswahlvorrichtung 5 aus. In einem Schritt iii) drückt der Monteur den Betätigungsschalter 8, wodurch an dem Energieversorgungsanschlusskontakt 9a die Versorgungsspannung Vs gemäß dem gewählten Versorgungsspannungslevel 7 ausgegeben wird. Dadurch wird die Tür- und/oder Torkomponente 12 mit elektrischer Energie versorgt. Durch die Versorgung mit elektrischer Energie kann die Tür- und/oder Torkomponente 12 initialisiert werden (Schritt iv)). Beispielsweise kann die Komponentensteuerung 24 ein Steuerungsprogramm laden. Nach einer Wartezeit von beispielsweise sieben Sekunden wird die erforderliche Spannungshöhe der Ansteuerungsspannung Va bestimmt. Dabei wird die Komponentenspannung Vk gemessen und mit der Spannungsschwelle S verglichen. Nach Bestimmung der erforderlichen Spannungshöhe der Ansteuerungsspannung Va wird die Ansteuerungsspannung Va in Schritt v) gemäß der ersten V1 oder der zweiten Spannungshöhe V2 ausgegeben. Dadurch wird die Tür- und/oder Torkomponente 12 in Schritt vi) angesteuert. Ein Monteur kann in Schritt vii) akustisch und/oder visuell feststellen, ob die Tür- und/oder Torkomponente 12 angesteuert wurde.

Der Monteur kann auch Tür- und/oder Torkontaktschalter 27 wie oben beschrieben überprüfen, indem diese mit einem Anschlusskontakt 9d für einen Tür- und/oder Torkontaktschalter 27 verbunden werden. Hierbei kann zum Beispiel ebenfalls eine Wartezeit vorgesehen sein, um die Tür- und/oder Torkontaktschalter 27 zu initialisieren.

Der Prüfvorgang kann mittels einer Kamera, beispielsweise einer Smartphone-Kamera, erfasst, gespeichert und dadurch dokumentiert werden. Dabei kann auch eine Identifikationsnummer der Tür- und/oder Torkomponente 12 oder der Tür bzw. des Tores erfasst werden, in welche die Tür- und/oder Torkomponente 12 integriert ist. Mit der Identifikationsnummer ist eine eindeutige Identifizierung der Tür- und/oder Torkomponente 12 oder der Tür bzw. des Tores möglich. Die Identifikationsnummer kann beispielsweise in Form eines QR-Codes vorliegen und von einem Programm, beispielsweise einer Smartphone-App erkannt werden. Das Programm kann die Identifikationsnummer mit der Filmdatei des Prüfablaufs verknüpfen. Auf diese Weise kann der Prüfvorgang dokumentiert werden.

## Patentansprüche

1. Prüfgerät (1), insbesondere Handgerät, zur Überprüfung der Funktion einer an das Prüfgerät (1) anschließbaren Tür- und/oder Torkomponente (12), insbesondere eines Türöffners, eines Türschlosses (13) und/oder eines Türkontaktschalters (27a), wobei das Prüfgerät (1) folgendes aufweist:
ein Gehäuse (2);
Anschlusskontakte (9) zur elektrischen Verbindung mit der Tür- und/oder Torkomponente (12); und
eine Energieversorgungseinrichtung (15), welche dazu eingerichtet ist, an zumindest einem der Anschlusskontakte (9) eine Versorgungsspannung (Vs) auszugeben;
**dadurch gekennzeichnet, dass** das Prüfgerät (1) eine Komponentenansteuerungseinrichtung (19) aufweist, welche dazu eingerichtet ist, eine an einem Komponentenkontakt (22) der anschließbaren Tür- und/oder Torkomponente (12) anliegende Komponentenspannung (Vk) über einen der Anschlusskontakte (9) zu erfassen und auf Basis der erfassten Komponentenspannung (Vk) eine Ansteuerungsspannung (Va), insbesondere einer Spannungshöhe der Ansteuerungsspannung (Va), zu bestimmen, mit der die Tür- und/oder Torkomponente (12) ansteuerbar ist.

2. Prüfgerät (1) nach Anspruch 1, **dadurch gekennzeichnet, dass** die Komponentenansteuerungseinrichtung (19) dazu eingerichtet ist, die Komponentenspannung (Vk) mittels einer Messeinheit (21) zu erfassen und die Ansteuerungsspannung (Va) an einem der Anschlusskontakte (9), insbesondere an jenem Anschlusskontakt (9), über den die Komponentenspannung (Vk) gemessen wird, auszugeben, wobei die Ansteuerungsspannung (Va) eine erste Spannungshöhe (V1) aufweist, wenn die gemessene Komponentenspannung (Vk) unterhalb einer Spannungsschwelle (S) liegt, und die Ansteuerungsspannung (Va) eine zweite Spannungshöhe (V2) aufweist, wenn die gemessene Komponentenspannung (Vk) oberhalb der Spannungsschwelle (S) liegt.

3. Prüfgerät (1) nach Anspruch 1 oder 2, **dadurch gekennzeichnet, dass** zumindest drei Anschlusskontakte (9) an dem Gehäuse (2) vorgesehen sind, wobei ein Bezugspotentialanschlusskontakt (9b) dazu eingerichtet ist, ein Bezugspotential (P) auszugeben, ein Energieversorgungsanschlusskontakt (9a) dazu eingerichtet ist, die Versorgungsspannung (Va) auszugeben, und ein Ansteuerungsanschlusskontakt (9c) dazu eingerichtet ist, die Ansteuerungsspannung (Va), insbesondere einen Ansteuerungsspannungssprung oder - impuls, auszugeben.

4. Prüfgerät (1) nach Anspruch 2 und 3, **dadurch gekennzeichnet, dass** die erste Spannungshöhe (V1) im Wesentlichen der Höhe der Versorgungsspannung (Vs) und die zweite Spannungshöhe (V2) im Wesentlichen der Höhe des Bezugspotentials (P) entspricht.

5. Prüfgerät (1) nach Anspruch 3 oder 4, **dadurch gekennzeichnet, dass** an dem Gehäuse (2) ein Betätigungsschalter (8) vorgesehen ist, welcher dazu eingerichtet ist, die Komponentenansteuerungseinrichtung (19) zu veranlassen, die Versorgungsspannung (Vs) an dem Energieversorgungsanschlusskontakt (9a) auszugeben und/oder die Ansteuerungsspannung (Va) an dem Ansteuerungsanschlusskontakt (9c) auszugeben, vorzugsweise wobei die Ansteuerungsspannung (Va) zeitlich versetzt zur Versorgungsspannung (Vs) ausgegeben wird.

6. Prüfgerät (1) nach Anspruch 5, **dadurch gekennzeichnet, dass** die Komponentenansteuerungseinrichtung (19) dazu eingerichtet ist, nach Ausgabe der Versorgungsspannung (Vs) eine Wartezeit von zumindest drei Sekunden, zumindest fünf Sekunden oder zumindest sieben Sekunden einzuhalten, bevor die Ansteuerungsspannung (Va) bestimmt wird.

7. Prüfgerät (1) nach einem der Ansprüche 1 bis 6, **dadurch gekennzeichnet, dass** zumindest ein Anschlusskontakt (9d) für einen Tür- und/oder Torkontaktschalter (27) vorgesehen ist und eine Anzeigeeinrichtung (30) mit dem Anschlusskontakt (9d) für den Tür- und/oder Torkontaktschalter (27) verbunden ist, wobei die Anzeigeeinrichtung (30) dazu eingerichtet ist, eine an dem Anschlusskontakt (9d) für den Tür- und/oder Torkontaktschalter (27) anliegende Kontaktspannung (Vkontakt) zu signalisieren.

8. Prüfgerät (1) nach einem der Ansprüche 1 bis 7, **dadurch gekennzeichnet, dass** die Energieversorgungseinrichtung (15) dazu eingerichtet ist, die Versorgungsspannung (Vs) gemäß zumindest zwei unterschiedlicher Versorgungsspannungslevel (7) auszugeben.

9. Prüfgerät (1) nach Anspruch 8, **dadurch gekennzeichnet, dass** eine Auswahlvorrichtung (5), insbesondere zumindest ein Schalter, vorgesehen ist, sodass ein erster Versorgungsspannungslevel (7a), insbesondere im Wesentlichen 12 Volt, oder ein zweiter Versorgungsspannungslevel (7b), insbesondere im Wesentlichen 24 V, auswählbar ist.

10. Verfahren zur Überprüfung der Funktion einer Tür- und/oder Torkomponente (12), wobei ein Prüfgerät (1) nach einem der Ansprüche 1 bis 9 mit den Anschlusskontakten (9) mittels zumindest einer Verbindungsleitung (11) direkt oder indirekt an eine Tür- und/oder Torkomponente (12), insbesondere an einen Türöffner, ein Türschloss (13) oder einen Türkontaktschalter (27a), angeschlossen wird;
**gekennzeichnet durch** die Schritte:
Erfassen einer an einem Komponentenkontakt (22) der Tür- und/oder Torkomponente (12) anliegenden Komponentenspannung (Vk) über einen der Anschlusskontakte (9), insbesondere über einen Ansteuerungsanschlusskontakt (9c);
Bestimmen einer Ansteuerungsspannung (Va), mit der die Tür- und/oder Torkomponente (12) ansteuerbar ist, auf Basis der erfassten Komponentenspannung (Vk);
Ansteuern der Tür- und/oder Torkomponente (12) durch Ausgeben der Ansteuerungsspannung (Va) an einem der Anschlusskontakte (9), vorzugsweise in Form eines Ansteuerungsspannungssprungs oder -impuls.

11. Verfahren nach Anspruch 10, **dadurch gekennzeichnet, dass** die Komponentenspannung (Vk) erfasst wird und an einem der Anschlusskontakte (9), insbesondere an jenem Anschlusskontakt (9), über den die Komponentenspannung (Vk) erfasst wird, die Ansteuerungsspannung (Va) ausgegeben wird, wobei die Ansteuerungsspannung (Va) eine erste Spannungshöhe (V1) aufweist, wenn die gemessene Komponentenspannung (Vk) unterhalb einer Spannungsschwelle (S) liegt, und die Ansteuerungsspannung (Va) eine zweite Spannungshöhe (V2) aufweist, wenn die gemessene Komponentenspannung (Vk) oberhalb der Spannungsschwelle (S) liegt.

12. Verfahren nach Anspruch 11, **dadurch gekennzeichnet, dass** an einem als Ansteuerungsanschlusskontakt (9c) ausgebildeten Anschlusskontakt (9) die Komponentenspannung (Vk) gemessen wird und die Ansteuerungsspannung (Va) an dem Ansteuerungsanschlusskontakt (9c) ausgegeben wird, vorzugsweise als Ansteuerungsspannungssprung oder -impuls.

13. Verfahren nach einem der Ansprüche 10 bis 12, **dadurch gekennzeichnet, dass** die Versorgungsspannung (Vs) an einem Energieversorgungsanschlusskontakt (9a) und/oder die Ansteuerungsspannung (Va) an einem Ansteuerungsanschlusskontakt (9c) ausgegeben wird, wenn ein Benutzer einen Betätigungsschalter (8) drückt, vorzugsweise wobei die Ansteuerungsspannung (Va) zeitversetzt zur Versorgungsspannung (Vs) an die Tür- und/oder Torkomponente (12) ausgegeben wird.

14. Verfahren nach Anspruch 13, **dadurch gekennzeichnet, dass** nach Betätigung des Betätigungsschalters (8) die Versorgungsspannung (Vs) ausgegeben wird, anschließend die Ansteuerungsspannung (Va) bestimmt wird und dann die Ansteuerungsspannung (Va) ausgegeben wird.

15. Verfahren nach Anspruch 14, **dadurch gekennzeichnet, dass** zwischen der Ausgabe der Versorgungsspannung (Vs) und der Bestimmung der Ansteuerungsspannung (Va) eine Wartezeit von zumindest drei Sekunden, von zumindest 5 Sekunden, von zumindest 6 Sekunden oder von zumindest 7 Sekunden eingehalten wird.

## Geänderte Patentansprüche

### Geänderte Patentansprüche gemäss Regel 137(2) EPÜ.

1. Prüfgerät (1) zur Überprüfung der Funktion einer an das Prüfgerät (1) anschließbaren Tür- und/oder Torkomponente (12), insbesondere eines Türöffners, eines Türschlosses (13) und/oder eines Türkontaktschalters (27a), wobei das Prüfgerät (1) als Handgerät (51) ausgebildet ist und folgendes aufweist:
ein Gehäuse (2);
Anschlusskontakte (9) zur elektrischen Verbindung mit der Tür- und/oder Torkomponente (12); und
eine Energieversorgungseinrichtung (15), welche dazu eingerichtet ist, an zumindest einem der Anschlusskontakte (9) eine Versorgungsspannung (Vs) auszugeben;
**dadurch gekennzeichnet, dass** das Prüfgerät (1) eine Komponentenansteuerungseinrichtung (19) aufweist, welche dazu eingerichtet ist, eine an einem Komponentenkontakt (22) der anschließbaren Tür- und/oder Torkomponente (12) anliegende Komponentenspannung (Vk) über einen der Anschlusskontakte (9) zu erfassen und auf Basis der erfassten Komponentenspannung (Vk) eine Ansteuerungsspannung (Va), insbesondere einer Spannungshöhe der Ansteuerungsspannung (Va), zu bestimmen, mit der die Türund/oder Torkomponente (12) ansteuerbar ist.

2. Prüfgerät (1) nach Anspruch 1, **dadurch gekennzeichnet, dass** die Komponentenansteuerungseinrichtung (19) dazu eingerichtet ist, die Komponentenspannung (Vk) mittels einer Messeinheit (21) zu erfassen und die Ansteuerungsspannung (Va) an einem der Anschlusskontakte (9), insbesondere an jenem Anschlusskontakt (9), über den die Komponentenspannung (Vk) gemessen wird, auszugeben, wobei die Ansteuerungsspannung (Va) eine erste Spannungshöhe (V1) aufweist, wenn die gemessene Komponentenspannung (Vk) unterhalb einer Spannungsschwelle (S) liegt, und die Ansteuerungsspannung (Va) eine zweite Spannungshöhe (V2) aufweist, wenn die gemessene Komponentenspannung (Vk) oberhalb der Spannungsschwelle (S) liegt.

3. Prüfgerät (1) nach Anspruch 1 oder 2, **dadurch gekennzeichnet, dass** zumindest drei Anschlusskontakte (9) an dem Gehäuse (2) vorgesehen sind, wobei ein Bezugspotentialanschlusskontakt (9b) dazu eingerichtet ist, ein Bezugspotential (P) auszugeben, ein Energieversorgungsanschlusskontakt (9a) dazu eingerichtet ist, die Versorgungsspannung (Va) auszugeben, und ein Ansteuerungsanschlusskontakt (9c) dazu eingerichtet ist, die Ansteuerungsspannung (Va), insbesondere einen Ansteuerungsspannungssprung oder - impuls, auszugeben.

4. Prüfgerät (1) nach Anspruch 2 und 3, **dadurch gekennzeichnet, dass** die erste Spannungshöhe (V1) im Wesentlichen der Höhe der Versorgungsspannung (Vs) und die zweite Spannungshöhe (V2) im Wesentlichen der Höhe des Bezugspotentials (P) entspricht.

5. Prüfgerät (1) nach Anspruch 3 oder 4, **dadurch gekennzeichnet, dass** an dem Gehäuse (2) ein Betätigungsschalter (8) vorgesehen ist, welcher dazu eingerichtet ist, die Komponentenansteuerungseinrichtung (19) zu veranlassen, die Versorgungsspannung (Vs) an dem Energieversorgungsanschlusskontakt (9a) auszugeben und/oder die Ansteuerungsspannung (Va) an dem Ansteuerungsanschlusskontakt (9c) auszugeben, vorzugsweise wobei die Ansteuerungsspannung (Va) zeitlich versetzt zur Versorgungsspannung (Vs) ausgegeben wird.

6. Prüfgerät (1) nach Anspruch 5, **dadurch gekennzeichnet, dass** die Komponentenansteuerungseinrichtung (19) dazu eingerichtet ist, nach Ausgabe der Versorgungsspannung (Vs) eine Wartezeit von zumindest drei Sekunden, zumindest fünf Sekunden oder zumindest sieben Sekunden einzuhalten, bevor die Ansteuerungsspannung (Va) bestimmt wird.

7. Prüfgerät (1) nach einem der Ansprüche 1 bis 6, **dadurch gekennzeichnet, dass** zumindest ein Anschlusskontakt (9d) für einen Tür- und/oder Torkontaktschalter (27) vorgesehen ist und eine Anzeigeeinrichtung (30) mit dem Anschlusskontakt (9d) für den Tür- und/oder Torkontaktschalter (27) verbunden ist, wobei die Anzeigeeinrichtung (30) dazu eingerichtet ist, eine an dem Anschlusskontakt (9d) für den Tür- und/oder Torkontaktschalter (27) anliegende Kontaktspannung (Vkontakt) zu signalisieren.

8. Prüfgerät (1) nach einem der Ansprüche 1 bis 7, **dadurch gekennzeichnet, dass** die Energieversorgungseinrichtung (15) dazu eingerichtet ist, die Versorgungsspannung (Vs) gemäß zumindest zwei unterschiedlicher Versorgungsspannungslevel (7) auszugeben.

9. Prüfgerät (1) nach Anspruch 8, **dadurch gekennzeichnet, dass** eine Auswahlvorrichtung (5), insbesondere zumindest ein Schalter, vorgesehen ist, sodass ein erster Versorgungsspannungslevel (7a), insbesondere im Wesentlichen 12 Volt, oder ein zweiter Versorgungsspannungslevel (7b), insbesondere im Wesentlichen 24 V, auswählbar ist.

10. Verfahren zur Überprüfung der Funktion einer Tür- und/oder Torkomponente (12), wobei ein Prüfgerät (1) nach einem der Ansprüche 1 bis 9 mit den Anschlusskontakten (9) mittels zumindest einer Verbindungsleitung (11) direkt oder indirekt an eine Türund/oder Torkomponente (12), insbesondere an einen Türöffner, ein Türschloss (13) oder einen Türkontaktschalter (27a), angeschlossen wird;
**gekennzeichnet durch** die Schritte:
Erfassen einer an einem Komponentenkontakt (22) der Türund/oder Torkomponente (12) anliegenden Komponentenspannung (Vk) über einen der Anschlusskontakte (9), insbesondere über einen Ansteuerungsanschlusskontakt (9c);
Bestimmen einer Ansteuerungsspannung (Va), mit der die Türund/oder Torkomponente (12) ansteuerbar ist, auf Basis der erfassten Komponentenspannung (Vk);
Ansteuern der Tür- und/oder Torkomponente (12) durch Ausgeben der Ansteuerungsspannung (Va) an einem der Anschlusskontakte (9), vorzugsweise in Form eines Ansteuerungsspannungssprungs oder -impuls.

11. Verfahren nach Anspruch 10, **dadurch gekennzeichnet, dass** die Komponentenspannung (Vk) erfasst wird und an einem der Anschlusskontakte (9), insbesondere an jenem Anschlusskontakt (9), über den die Komponentenspannung (Vk) erfasst wird, die Ansteuerungsspannung (Va) ausgegeben wird, wobei die Ansteuerungsspannung (Va) eine erste Spannungshöhe (V1) aufweist, wenn die gemessene Komponentenspannung (Vk) unterhalb einer Spannungsschwelle (S) liegt, und die Ansteuerungsspannung (Va) eine zweite Spannungshöhe (V2) aufweist, wenn die gemessene Komponentenspannung (Vk) oberhalb der Spannungsschwelle (S) liegt.

12. Verfahren nach Anspruch 11, **dadurch gekennzeichnet, dass** an einem als Ansteuerungsanschlusskontakt (9c) ausgebildeten Anschlusskontakt (9) die Komponentenspannung (Vk) gemessen wird und die Ansteuerungsspannung (Va) an dem Ansteuerungsanschlusskontakt (9c) ausgegeben wird, vorzugsweise als Ansteuerungsspannungssprung oder -impuls.

13. Verfahren nach einem der Ansprüche 10 bis 12, **dadurch gekennzeichnet, dass** die Versorgungsspannung (Vs) an einem Energieversorgungsanschlusskontakt (9a) und/oder die Ansteuerungsspannung (Va) an einem Ansteuerungsanschlusskontakt (9c) ausgegeben wird, wenn ein Benutzer einen Betätigungsschalter (8) drückt, vorzugsweise wobei die Ansteuerungsspannung (Va) zeitversetzt zur Versorgungsspannung (Vs) an die Tür- und/oder Torkomponente (12) ausgegeben wird.

14. Verfahren nach Anspruch 13, **dadurch gekennzeichnet, dass** nach Betätigung des Betätigungsschalters (8) die Versorgungsspannung (Vs) ausgegeben wird, anschließend die Ansteuerungsspannung (Va) bestimmt wird und dann die Ansteuerungsspannung (Va) ausgegeben wird.

15. Verfahren nach Anspruch 14, **dadurch gekennzeichnet, dass** zwischen der Ausgabe der Versorgungsspannung (Vs) und der Bestimmung der Ansteuerungsspannung (Va) eine Wartezeit von zumindest drei Sekunden, von zumindest 5 Sekunden, von zumindest 6 Sekunden oder von zumindest 7 Sekunden eingehalten wird.
